# EUROPÄISCHE PATENTSCHRIFT

(11) **EP 1 632 711 B1**
(45) Veröffentlichungstag und Bekanntmachung des Hinweises auf die Patenterteilung: **18.11.2009**
(21) Anmeldenummer: 05450145.7
(22) Anmeldetag: 31.08.2005
(51) Int. Cl.: F21S 8/10, F21V 19/00, B60Q 1/26

(54) **Lichtquellen-Trageinheit**
Supporting assembly for light sources
Support pour sources de lumière

(30) Priorität: 01.09.2004 AT 14652004
(43) Veröffentlichungstag der Anmeldung: 08.03.2006
(73) Patentinhaber: Pollmann Austria OHG, 3822 Karlstein/Thaya (AT)
(72) Erfinder: Wimmer, Walter, 3823 Weikertschlag/Thaya 29 (AT)
(74) Vertreter: Sonn & Partner Patentanwälte

(56) Entgegenhaltungen:
- EP-A- 1 069 371
- EP-A- 1 304 260
- DE-A1- 10 225 543
- DE-A1- 19 720 106

## Beschreibung

Die Erfindung betrifft eine Lichtquellen-Trageinheit mit einem Tragkörper, der wenigstens einen Montagebereich für die Montage zumindest einer Lichtquelle, vorzugsweise einer LED, aufweist, und der eine Bezugsebene definiert, gegenüber welcher die Lichtabstrahlrichtung der Lichtquelle in der vorgegebenen Betriebsposition geneigt verläuft, wobei der Montagebereich durch einen mit dem übrigen Tragkörper beweglich verbundenen Sockel gebildet ist, der relativ zum Tragkörper aus einer anfänglichen Lichtquellen-Montageposition, entsprechend der Bezugsebene, in die Betriebsposition bewegbar ist.

Lichtquellen-Trageinheiten dienen insbesondere zur Anbringung von Leuchten, wie etwa Schluss- bzw. Rückleuchten, Blinkleuchten, usw., in Kraftfahrzeugen, wobei die Technologie dahingeht, Licht emittierende Dioden (LEDs) für derartige KFZ-Leuchten zu verwenden. Beispielsweise können 10 oder 20 LEDs im Zuge der Realisierung einer Schlussleuchte, eines Bremslichts oder einer Blinkleuchte eingesetzt werden, abhängig von der Stärke der LEDs. Dabei ergibt sich die Notwendigkeit, dass die Trageinheit mit dem Tragkörper nicht in exakter rechtwinkeliger oder paralleler Ausrichtung, bezogen auf die Fahrtrichtung des Kraftfahrzeuges, an einem Karosserieteil des letzteren montiert werden kann, so dass beim Montieren der Lichtquellen, insbesondere LEDs, auf dem Tragkörper in einem Automaten (Roboter) ein dreidimensionales (3D-)Bestücken oder Montieren erforderlich ist. Im Zuge einer solchen Bestückung werden beispielsweise LEDs auf mit Leiterbahnen versehene Tragkörper, die erhitzt werden, um das Leitermaterial fließfähig zu machen, aufgedrückt und fixiert. Ein derartiges 3D-Bestücken ist jedoch aufwendig und mühsam, wobei kostenintensive Automaten mit entsprechend umfangreicher für die x-, y- und z-Steuerung erforderlich sind. Demgegenüber sind Automaten, die eine 2D-Bestückung durchführen, vom Bestücken von Leiterplatten bekannt und in der Technik gut eingeführt, und sie sind vergleichsweise einfach und billig. Es besteht daher Bedarf an einer Technologie, die trotz des Einbaus einer Lichtquellen-Trageinheit in einer vorgegebenen Winkellage eine 2D-Bestückung von Trageinheiten mit Lichtquellen ermöglicht.

In der DE 102 25 543 A1 ist eine Trägereinheit für Leuchtelemente wie eingangs angegeben beschrieben, die einen Hauptabschnitt und mehrere flügel- und /oder lappenförmige Schwenkelemente aufweist. Die Schwenkelemente, welche je mindestens eine LED tragen, sind durch Schwenkgelenke , die in Form von scharnierartigen Materialverdünnungen vorliegen, mit dem Träger verbunden. Der Schwenkwinkel kann durch eine keilförmige Ausführung des Gelenkes begrenzt werden.

Aus der EP 1 304 260 A1 ist allgemein ein Rückspiegel für Fahrzeuge mit kompatiblen, kombinierbaren und austauschbaren Modulen bekannt, die eine Lichtsignalleiste umfassen können. Diese Lichtsignalleiste besteht aus einer flexiblen Basis, auf der eine Anzahl LEDs angeordnet ist. In diese Basis sind Schlitze eingebracht, die in einem Winkel abstehende Laschen formen, auf denen je eine LED platziert ist. Die flexible Basis wird dann in die gewünschte, dem Rückspiegel entsprechende Form gebogen.

Die DE 197 20 106 A1 offenbart eine Leiterplatte, die an einem Gehäuse befestigt wird. Die Leiterplatte kann starr oder flexibel ausgeführt sein. Wenn sie starr ausgeführt ist, kann sie aus mehreren Plattenteilen bestehen, die über scharnierartige Verbindungen miteinander verbunden sind. Die aus den Teilen bestehende Leiterplatte wird entsprechend dem Gehäuse, auf dem die Leiterplatte aufgebracht wird, zusammengesetzt, um die auf den einzelnen Plattenteilen angeordneten Bauteile/-gruppen am Gehäuse richtig positionieren und ausrichten zu können, damit die Bauteile/-gruppen in die erforderliche Richtung zeigen.

Es ist nun Aufgabe der Erfindung, eine Lichtquellen-Trageinheit der eingangs angeführten Art vorzusehen, die eine Montage der Lichtquelle, insbesondere LED, in einer 2D-Bestückungstechnik ermöglicht, wobei andererseits nichtdestoweniger eine Anbringung der Trageinheit samt Lichtquelle in der jeweiligen Einrichtung, z.B. an einem Karosserieteil eines Kraftfahrzeuges, in einer vorgegebenen Winkellage derart möglich sein soll, dass dann die Abstrahlrichtung der Lichtquelle einer vorgegebenen Richtung, etwa der Längsrichtung oder Fahrtrichtung des Kraftfahrzeuges, entspricht; dabei soll eine stabile Ausrichtung der Lichtquelle in der Betriebsposition unter Fixierung des Sockels für die Lichtquelle in seiner Betriebsposition am Tragkörper möglich sein.

Zur Lösung der gestellten Aufgabe sieht die Erfindung eine Lichtquellen-Trageinheit wie in Anspruch 1 definiert vor; vorteilhafte Ausführungsformen und Weiterbildungen sind in den Unteransprüchen angegeben.

Bei der vorliegenden Lichtquellen-Trageinheit ist ein 2D-Bestücken, wie es etwa vom Bestücken von Leiterplatten her bekannt ist, bei der Montage der Lichtquellen möglich, wobei der Montagebereich der Trageinheit nicht fix an der Trageinheit vorgesehen ist, sondern durch einen relativ dazu (bzw. zur genannten Bezugsebene) verstellbaren Teil gebildet und durch die Verstellung die schließlich in der endgültigen Betriebsposition gewünschte Ausrichtung der Lichtquelle ermöglicht wird. Anders als bei einem fixen Tragkörper, bei dem die Bezugsebene - bedingt durch die Montagelage in der jeweiligen Einrichtung, insbesondere an einem Karosserieteil eines Kraftfahrzeuges, und die Montageebene der Lichtquelle (bzw. demgemäß die Lichtabstrahlrichtung der Lichtquelle) schräg zueinander angeordnet sind, wodurch die 3D-Bestückung notwendig ist, ist der den Montagebereich für die Lichtquelle bildende Sockel relativ zum übrigen Tragkörper beweglich, so dass der Sockel (zumindest) zwei Positionen gegenüber dem übrigen Tragkörper einnehmen kann: In der einen Position, der Montageposition für die Lichtquelle, ist eine derartige Ausrichtung des Montagebereichs des Sockels gegeben, dass eine Bestückung mit der Lichtquelle in einer 2D-Technik möglich ist. Nach erfolgter Lichtquellen-Montage, d.h. Bestückung, wird der Sockel samt darauf montierter Lichtquelle in die andere Position, die Betriebsposition, überführt, in der die vorerwähnte Winkellage relativ zur Bezugsebene gegeben ist, und in dieser Position verrastet. Da die erforderliche Neigung, d.h. Größe des Winkels, für diese Winkellage von vornherein bekannt ist, kann auch die Betriebsposition des Sockels relativ zum üblichen Tragkörper entsprechend durch Positioniermittel, wie Anschläge etc., festgelegt werden, und zwar je nach der erforderlichen Winkellage. Der Tragkörper kann dabei einfach zumindest im Wesentlichen plattenförmig sein, wobei die (obere) Plattenebene die Bezugsebene definiert bzw. parallel zur Bezugsebene verläuft. Der Sockel kann weiters am eigentlichen Tragkörper an einem Rand angeordnet sein, bevorzugt ist er jedoch in einer fensterartigen Öffnung des Tragkörpers - geschützt - angeordnet, wobei auch die Verrastung des Sockels in der Betriebsposition dann mit einer besonders hohen Stabilität möglich wird. Für eine einfache Herstellung und Handhabung im Zuge der Montage ist es weiters vorteilhaft, wenn der Sockel mit dem Tragkörper schwenkbar verbunden ist. An sich wäre es aber auch denkbar, wenn der Sockel relativ zum Tragteil verschieb- und schwenkbar ist. Um im Fall der schwenkbaren Verbindung von Sockel und Tragteil die Herstellung weiter zu vereinfachen, ist es zusätzlich günstig, wenn der Sockel mit dem Tragkörper einstückig ist und mit ihm über ein Filmscharnier schwenkbar verbunden ist.

Wie bereits einleitend erwähnt wird zur Herstellung der elektrischen Anschlüsse auf den Tragkörper ein Leiterbahnenmuster vorgesehen, und im Fall der letztgenannten Ausführungsform der erfindungsgemäßen Trageinheit ist es von besonderem Vorteil, wenn am Sockel sowie am Tragkörper über den Bereich des Filmscharniers führende flexible Leiterbahnen für den elektrischen Anschluss der Lichtquelle angeordnet sind. Derartige flexible Leiterbahnen sind an sich bekannt, und sie können beispielsweise mittels der so genannten MID-Technologie (MID - Molded Interconnect Device) vorgesehen werden. Hierbei werden vorgefertigte Leiterbahnenelemente beispielsweise in einem Heißpräge-Verfahren auf das Substrat, hier also auf den Tragkörper bzw. Sockel, unter Wärme- und Druckaufbringung aufgebracht. Die Leiterbahnenelemente können dabei selbst mit einer thermisch aktivierbaren oder aber auch anorganischen Haftschicht versehen sein, sie können aber auch als metallische Leiterbahnen in lokal erweichte Bereiche des Substrats (Tragkörper, Sockel) direkt eingepresst werden. Von Vorteil ist jedenfalls bei dieser Technik, dass die Oberfläche des Sockels in der Ausgangs-Montageposition in einer Ebene mit der Oberfläche des übrigen Tragkörpers liegt, so dass nicht nur die Bestückung mit den Lichtquellen in 2D-Technik, sondern auch die einfache Aufbringung der flexiblen Leiterbahnen ermöglicht wird.

Was die Rastelemente betrifft, so kann beispielsweise einfach der Sockel zumindest einen abstehenden Zapfenvorsprung aufweisen, der in eine Raste am Tragkörper einschnappt. Die Raste, d.h. die Rastvertiefung, wird entsprechend der Form des Zapfenvorsprungs geformt, und zum Einschnappen des Zapfenvorsprungs können in an sich herkömmlicher Weise Schrägflächen am die Raste bildenden Bereich des Tragkörpers vorgesehen sein. Besonders günstig ist es hierbei, wenn die Raste am Tragkörper nischenartig in einem am Tragkörper vorgesehenen Lagerteil gebildet ist, und wenn am Tragkörper weiters ein Anschlag für den Zapfenvorsprung vorgesehen ist, an welchem letzterer in der Betriebsposition anliegt. Eine hinsichtlich der Herstellung günstige Ausbildung ergibt sich hier weiters, wenn der Zapfenvorsprung an einem von einem plattenförmigen Hauptkörper des Sockels abstehenden Schenkel angebracht ist.

Bevorzugt werden zwei zu beiden Seiten des Sockels seitlich abstehende Zapfenvorsprünge vorgesehen; um weiters eine besonders gute Verankerung des Sockels am übrigen Tragkörper zu erzielen und zwar insbesondere - im Fall von zwei Zapfenvorsprüngen - in der Art einer 3-Punkt-Lagerung, ist es weiters günstig, wenn der Sockel einen mit dem Tragkörper verrastbaren Schnapphaken aufweist. Dabei kann der Schnapphaken einfach laschenartig vom übrigen Sockel, insbesondere von dessen plattenförmigem Hauptkörper, abstehen; weiters ist mit Vorteil am Tragkörper ein Steg vorgesehen, mit dem der Schnapphaken in der Betriebsposition mit einem Hakenende hintergreift.

Um das Bestücken zu erleichtern und ein Verrutschen von als Lichtquelle vorgesehenen LEDs zu verhindern, ist es ferner günstig, wenn der Sockel, z.B. leistenförmige, Positioniervorsprünge für eine LED aufweist.

Um eine einfache Herstellung der Trageinheit in einem Stück aus Kunststoff durch Spritzgießen in einem zweiteiligen Formwerkzeug, d.h. ohne Kernschieber, zu ermöglichen, ist es schließlich von Vorteil, wenn der Tragkörper zu den Rastelementen in der Montageposition des Sockels ausgerichtete Durchbrechungen aufweist. Dabei kann jeweils ein Formteil mit entsprechenden Vorsprüngen, die die Durchbrechungen im Tragkörper bilden und die die in Ausrichtung zu den Durchbrechungen vorgesehenen Rastelemente formen, vorgesehen werden, wobei dann ein Entformen durch Zurückziehen der Vorsprünge des Formteils durch die Durchbrechungen möglich ist.

Die Erfindung wird nachstehend anhand von bevorzugten Ausführungsbeispielen, auf die sie jedoch nicht beschränkt sein soll, noch weiter erläutert.

Es zeigen:
Fig. 1A ganz schematisch die Anordnung einer Trageinheit samt LED-Modul gemäß Stand der Technik an einem Karosserieteil eines Kraftfahrzeuges;
Fig. 1B eine vergleichbare schematische Ansicht einer solchen Trageinheit gemäß Stand der Technik - wie in Fig. 1A gezeigt - während des Bestückens mit einem LED-Modul in einer 3D-Technik;
Fig. 2 eine schaubildliche Darstellung einer erfindungsgemäßen Trageinheit mit LED-Modul in der Betriebsposition;
Fig. 3 eine schaubildliche Darstellung einer solchen Trageinheit samt LED-Modul in der LED-Montageposition, unmittelbar nach Montage der LED;
Fig. 4 und 5 eine Draufsicht bzw. Untersicht einer solchen Trageinheit in der LED-Montageposition;
Fig. 6 eine schaubildliche Unteransicht der Trageinheit in der Ausgangsposition;
Fig. 7 eine Seitenansicht der Trageinheit samt LED-Modul in der Ausgangsposition;
Fig. 8 und 9 Schnittdarstellungen der Trageinheit samt LED-Modul gemäß den Linien VIII-VIII bzw. IX-IX in Fig. 4;
Fig. 10 eine schaubildliche Ansicht der Trageinheit samt LED-Modul von schräg oben in einer Zwischenposition beim Überführen aus der Ausgangs-Montageposition in die Betriebsposition;
Fig. 11 eine schaubildliche Vorderansicht der Trageinheit samt LED-Modul von schräg unten in der Zwischenposition, wie in Fig. 10 gezeigt;
Fig. 12 eine Ansicht der Trageinheit samt LED-Modul in der Betriebsposition, ähnlich Fig. 2;
Fig. 13, 14, 15 und 16 die Trageinheit samt LED-Modul in der Betriebsposition, und zwar in einer Draufsicht, in einer Unteransicht, in einer schaubildlichen Unteransicht sowie in einer Seitenansicht;
Fig. 17 und 18 Schnittdarstellungen durch die Trageinheit samt LED-Modul in der Betriebsposition gemäß den Linien XVII-XVII bzw. XVIII-XVIII in Fig. 13; und
Fig. 19 eine Trageinheit mit einer Mehrzahl von LED-Modulen in der Betriebsposition.

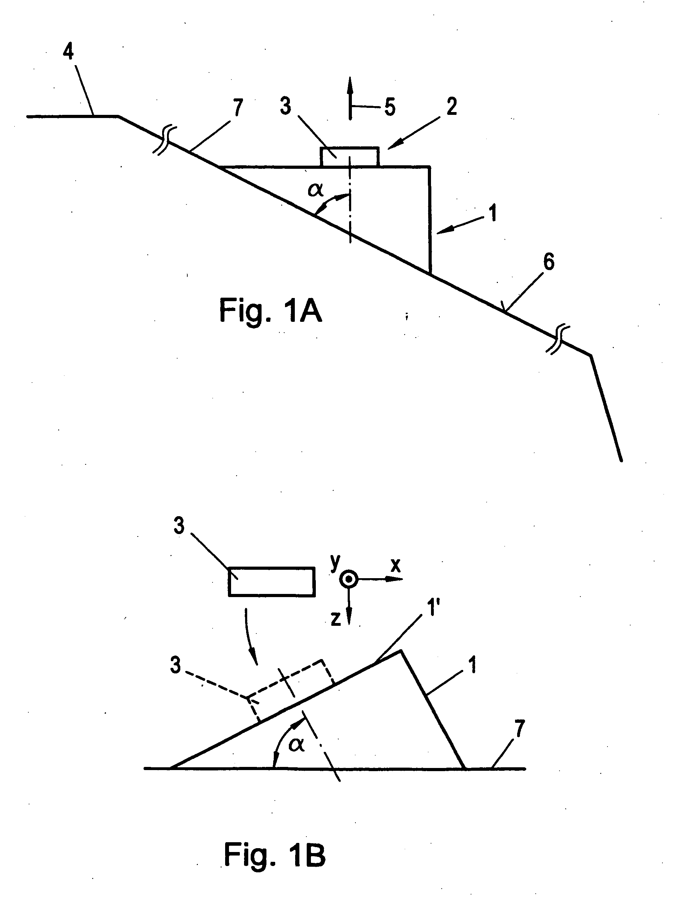

In Fig. 1A ist schematisch eine Trageinheit 1 mit einer daran montierten Lichtquelle 2 in Form eines LED-Moduls 3 in einer auf einem Karosserieteil oder sonstigen KFZ-Bauteils 4 eines sonst nicht näher dargestellten Kraftfahrzeuges montierten Betriebsposition veranschaulicht. Die so realisierte Kraftfahrzeug-Leuchte, z.B. eine Schlussleuchte oder eine Bremsleuchte, hat eine Lichtabstrahlrichtung, die mit einem Pfeil 5 veranschaulicht ist; diese Lichtabstrahl-Richtung 5 schließt einen von 90° abweichenden Winkel α mit der Fläche 6 des Karosserieteils 4 ein, wobei durch diese Fläche 6 eine Bezugsebene 7 definiert ist. Demgemäß liegt eine Winkellage (Winkel α) zwischen der Lichtabstrahlrichtung 5 und der Bezugsebene 7 vor.

Diese Bezugsebene 7 ist auch in Fig. 1B ersichtlich, wobei in dieser Fig. 1B der Vorgang des Bestückens der Trageinheit 1 mit dem LED-Modul 3 in einem Bestückungsautomaten veranschaulicht ist, der eine Unterlage für die Trageinheiten 3 (oder Auflage) aufweist, die auch die Bezugsebene 7 festlegt. Wie ersichtlich ist dabei eine dreidimensionale Bewegung bzw. Bestückung des LED-Moduls 3 erforderlich, was auch durch die Koordinatenachsen x-y-z in Fig. 1B veranschaulicht ist. Der dabei gegebene, von 90° verschiedene Winkel α, zu Folge der Winkellage des LED-Moduls 3 in der montierten Position relativ zur Bezugsebene 7, ist in Fig. 1B ebenfalls veranschaulicht; im Falle einer zweidimensionalen Bestückung, wie sie bei der Bestückung von Leiterplatten oder dgl. längst gut bekannter Stand der Technik ist, ist aufgrund der wesentlich einfacheren und preiswerteren Vorrichtungen und Verfahrensdurchführung wünschenswert, und hierfür ist es erforderlich, den Winkel α gemäß der Darstellung in Fig. 1A und 1B während der Montage der LED-Module oder allgemein Lichtquellen 2 auf einen Winkel von 90° zu bringen. Dies wird dadurch ermöglicht, dass an der Trageinheit ein beweglicher Montagebereich für die Lichtquelle vorgesehen wird, der aus einer Montageposition, in der die Motageebene 1' der Trageinheit 1 parallel zur Bezugsebene 7 ist, in eine endgültige Betriebsposition bewegt werden kann, in der der Winkel α zwischen der Lichtabstrahl-Richtung 5 und der Bezugsebene 7 erhalten wird.

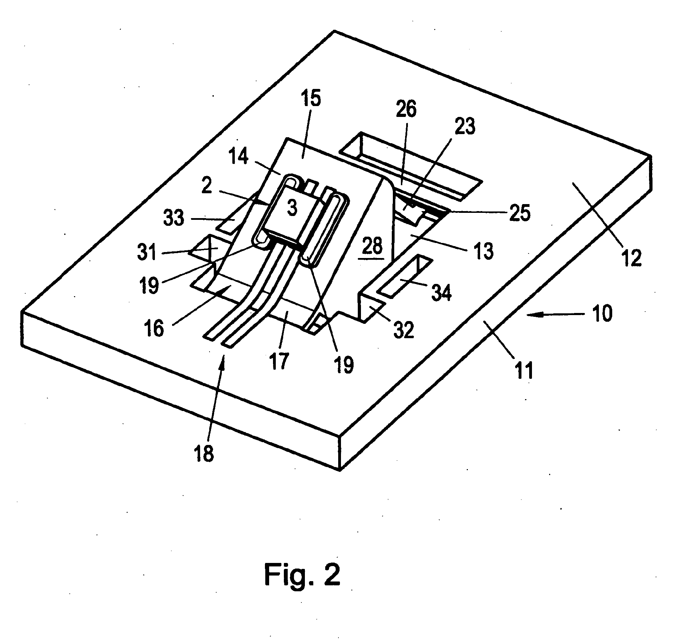

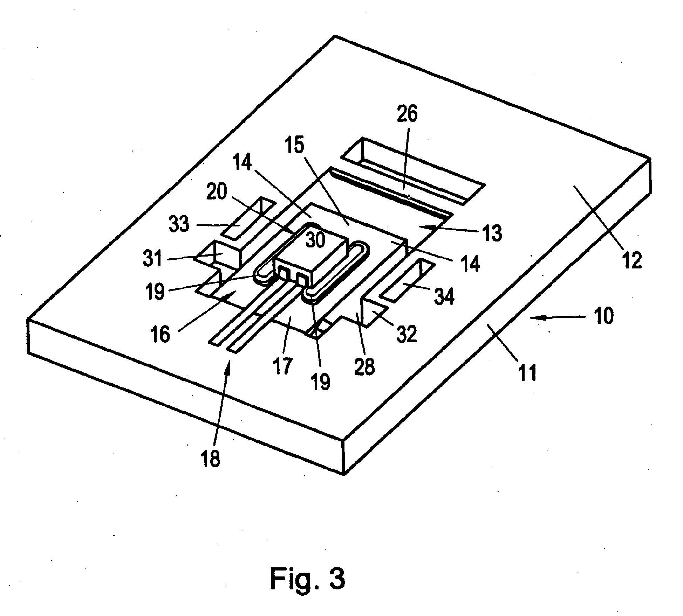

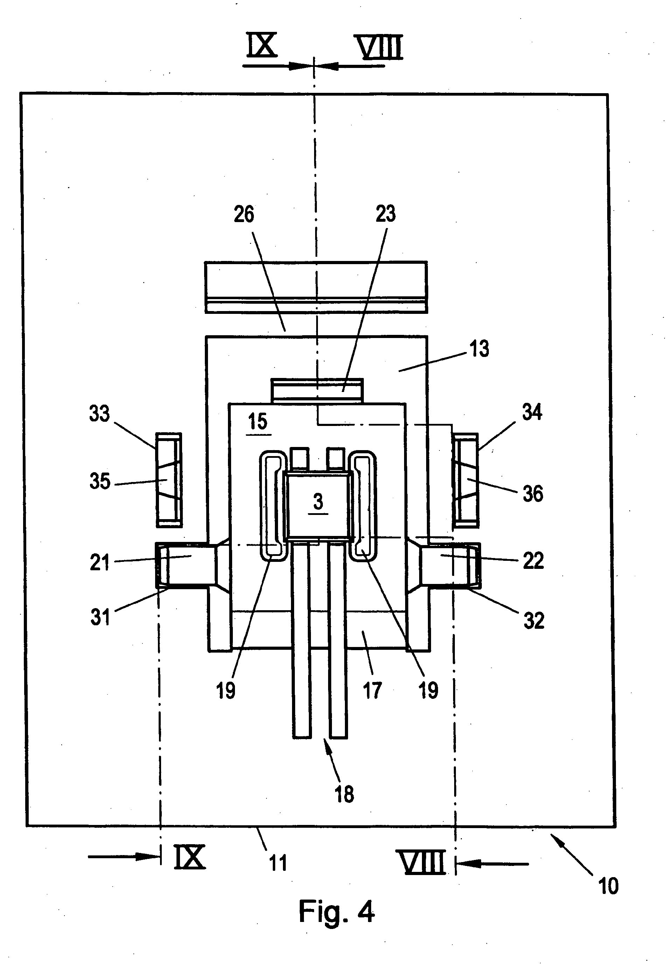

Im Einzelnen ist eine solche Trageinheit 10 in den Fig. 2 und 3 in der endgültigen Betriebsposition (Fig. 2) bzw. in der ursprünglichen Lichtquellen-Montageposition oder Ausgangsposition (Fig. 3) veranschaulicht. Wie dabei aus den Fig. 2 und 3 sowie auch aus den weiteren Fig. 4 bis 8 ersichtlich weist die Trageinheit 10 einen - zumindest im Wesentlichen - plattenförmigen Tragkörper 11 auf, dessen Oberseite oder obere Plattenebene 12 nunmehr als Bezugsebene entsprechend der Bezugsebene 7 in den Fig. 1A und 1B angesehen werden kann. Nachstehend soll daher diese obere Plattenebene auch als Bezugsebene 12 bezeichnet werden.

Im Tragkörper 11 ist eine fensterartige Öffnung 13 vorgesehen, in der als eigentlicher Montagebereich 14 ein Sockel 15 vorgesehen ist, welcher relativ zum Tragkörper 11 bewegbar ist. Im Einzelnen ist im gezeigten Ausführungsbeispiel der Sockel 15 mit dem Tragkörper 11 in einem Randbereich 16 schwenkbar verbunden, so dass er aus der Ausgangsposition gemäß Fig. 3, in der seine obere Ebene oder Montagefläche in einer Ebene zur Bezugsebene 12 liegt, in eine Winkellage gemäß Fig. 2, nämlich die Betriebslage, vgl. auch Fig. 1, hochgeschwenkt werden kann. Im Einzelnen ist dabei der Sockel 15 mit dem Tragkörper 11 im Randbereich 16 über ein Filmscharnier 17 mit dem Tragkörper 11, nämlich dem benachbarten Rand der fensterartigen Öfffnung 13, einstückig verbunden. In diesem Bereich sind auch Leiterbahnen 18 in an sich herkömmlicher Weise auf der Oberseite des Tragkörpers 11, des Filmscharniers 17 und des Sockels 15 angebracht, um elektrische Anschlüsse zum als Lichtquelle 2 zwischen Positionier-Anschlägen 19 gehaltenen LED-Modul 3 vorzusehen. Beim LED-Modul 3 kann es sich in an sich herkömmlicher Weise um eine so genannte SMD-LED handeln (SMD - Surface Mounted Device - Oberflächen-montierte Einrichtung), und die Leiterbahnen 18 können in der so genannten MID-Technik vorliegen (MID - Moulded Interconnect Device - geformte Verbindungseinrichtung); Derartige MID-Leiterbahnen werden wie an sich bekannt beispielsweise - vor Anbringung der LED 3 - in einem Heißpräge-Verfahren auf den Tragkörper 11 und den Sockel 15 samt Filmscharnier 17 aufgebracht.

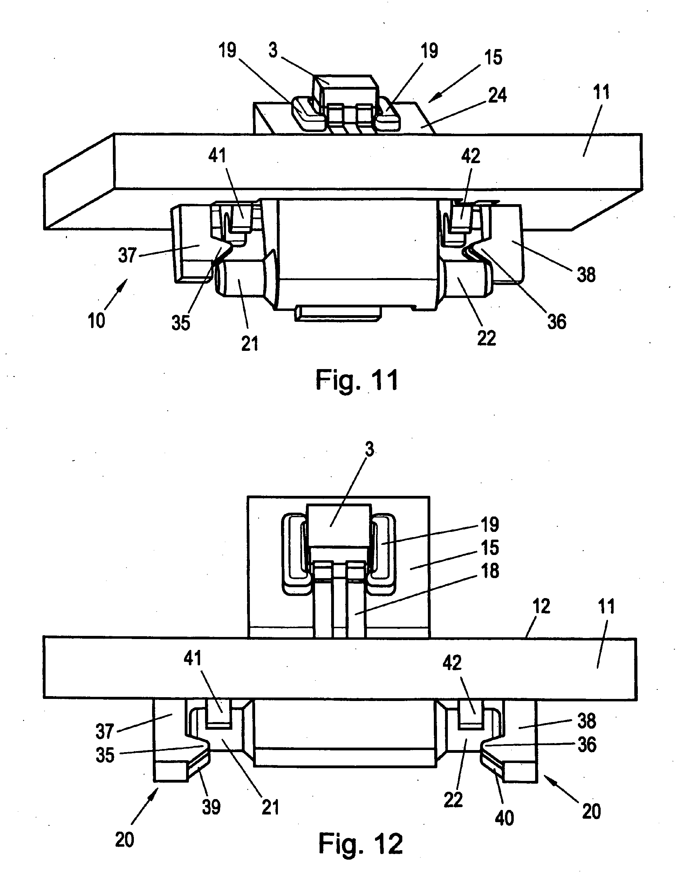

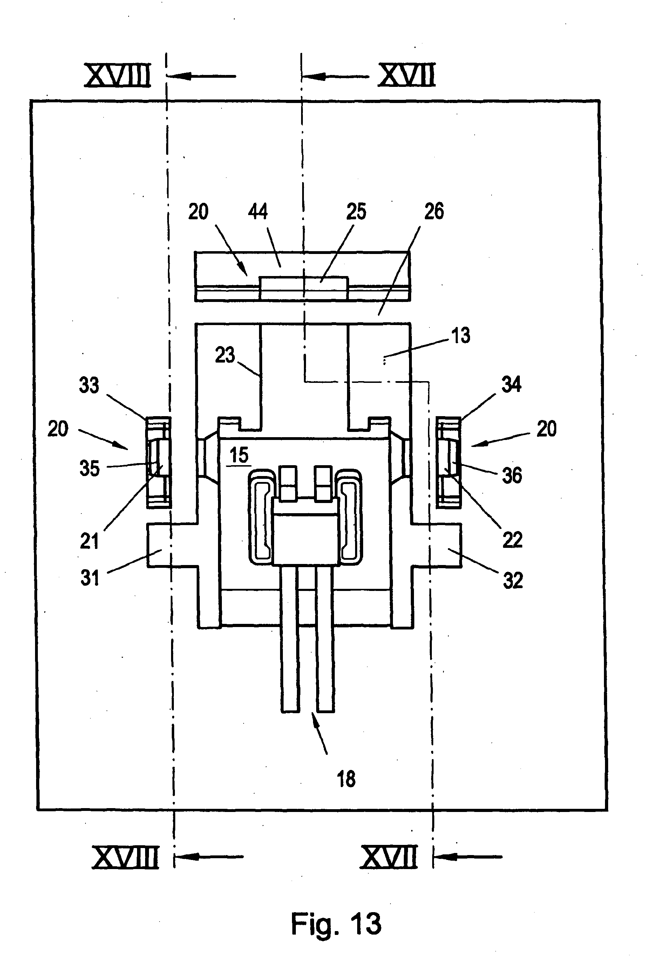

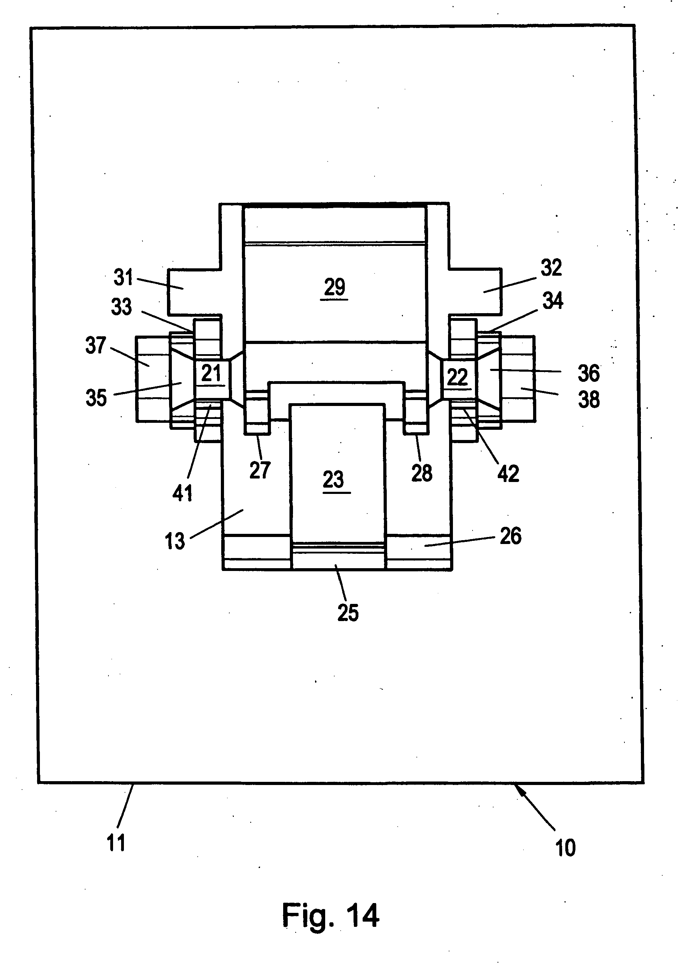

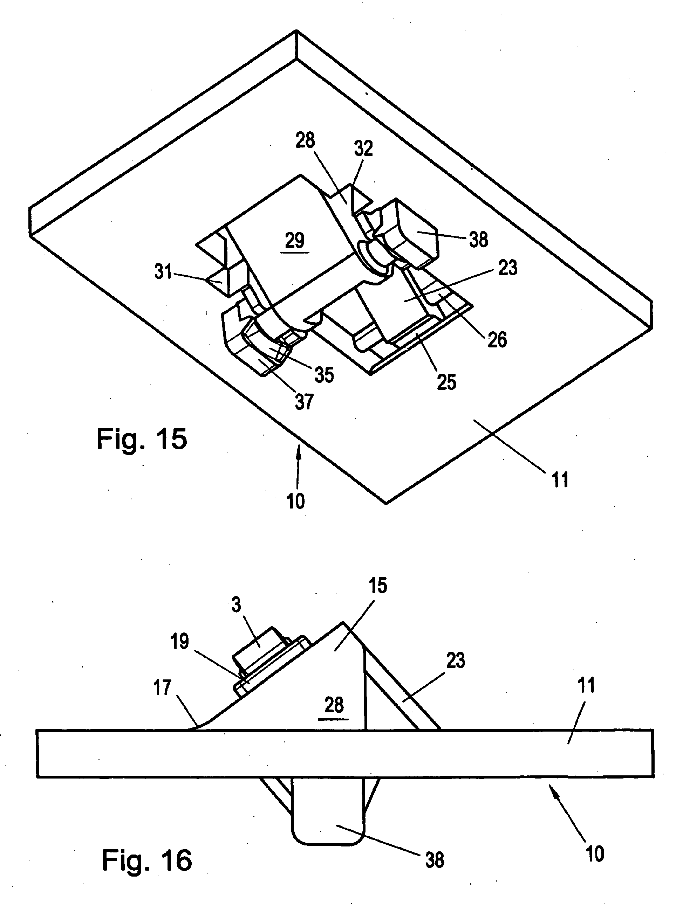

Um den Sockel 15 in seiner in Fig. 2 (vgl. auch die Fig. 12 bis 18) gezeigten, hochgeschwenkten Betriebsposition zu fixieren, ist der Sockel 15 im Wesentlichen unterseitig mit insgesamt drei Rastelementen 20 versehen, die in einer Art Dreipunkt-Lagerung in der Betriebsposition mit zugehörigen Rast- und Anlageelementen des Tragkörpers 11 zusammenarbeiten, wie nachstehend anhand der Fig. 12 bis 17 noch näher erläutert werden wird. Die Rastelemente 20 sind beim gezeigten Ausführungsbeispiel derart vorgesehen, dass ein Spritzgießen der gesamten Trageinheit 10 mit einer einfachen Spritzgussform bestehend aus einem Formoberteil und einem Formunterteil, ohne seitliche (Kern-)Schieber, möglich ist. Demgemäß weist auch der plattenförmige Tragkörper 11 zu diesen Rastelementen 20 ausgerichtete Durchbrechungen auf, wie nachstehend noch näher erläutert werden wird, und diese Durchbrechungen entstehen beim Spritzgießen durch entsprechende Formvorsprünge, die zur Formung der jeweiligen Rastelemente 20 dienen.

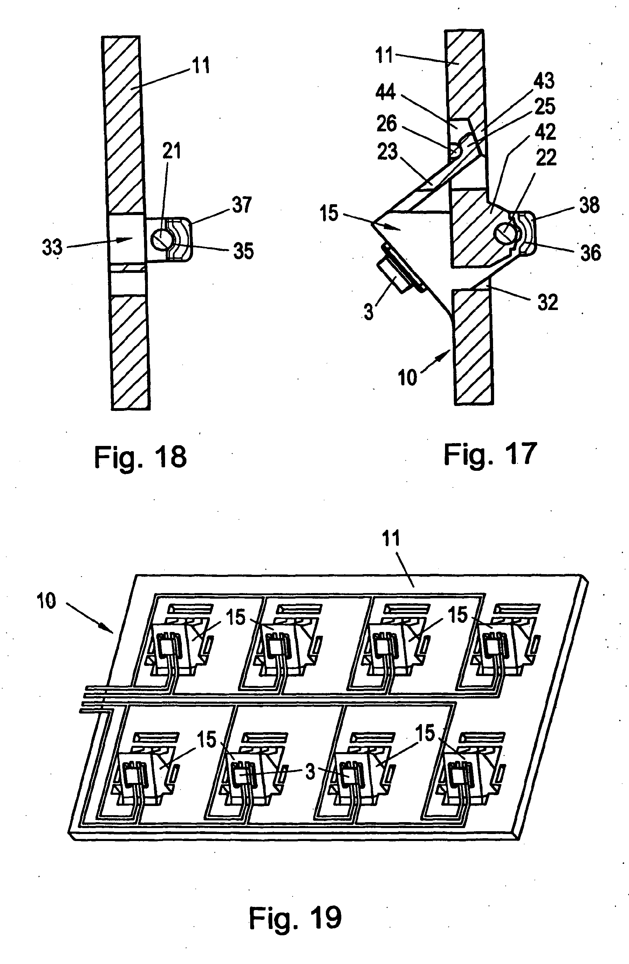

Im Einzelnen sind am Sockel 15 unterseitig (wenn die Bezugsebene 12 gemäß Fig. 3 als Oberseite bezeichnet wird) seitlich abstehende Zapfenvorsprünge 21, 22 sowie als weiteres Rastelement 20 ein laschenartig vom plattenförmigen Hauptkörper 24 nach unten abstehender Schnapphaken 23 vorgesehen. Dabei erstreckt sich dieser Schnapphaken 23 rechtwinkelig nach unten, wenn sich der Sockel 15 in der Ausgangsposition gemäß den Fig. 2 bis 9 befindet, und er weist ein abgewinkeltes Hakenende 25 auf, mit dem er in der endgültigen Betriebsposition gemäß den Fig. 12 bis 18 einen im Fenster 13 des Tragkörpers 11 vorgesehenen, sich quer erstreckenden Steg 26 hintergreift, vgl. insbesondere Fig. 17.

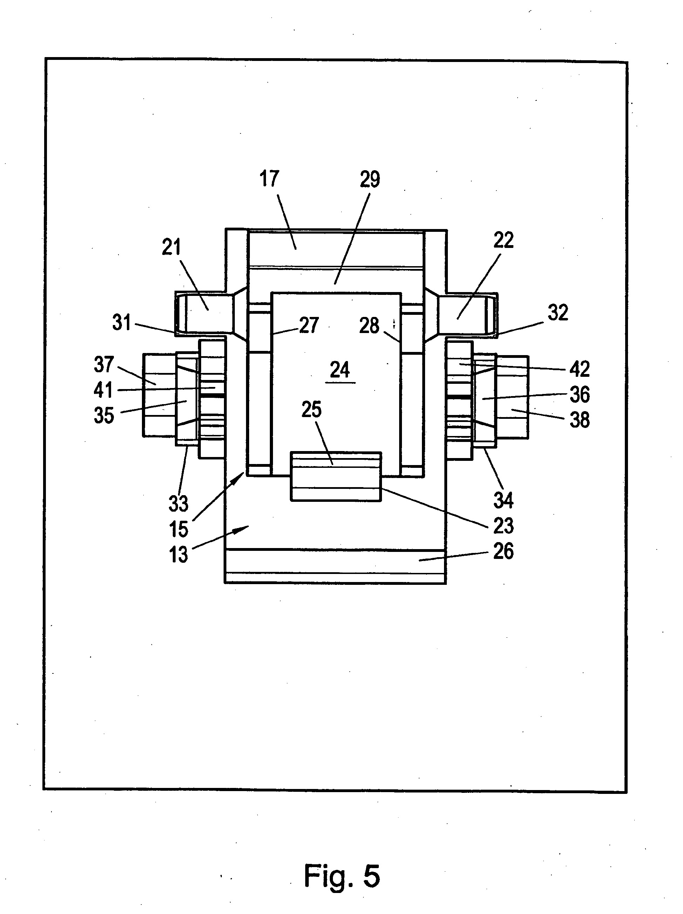

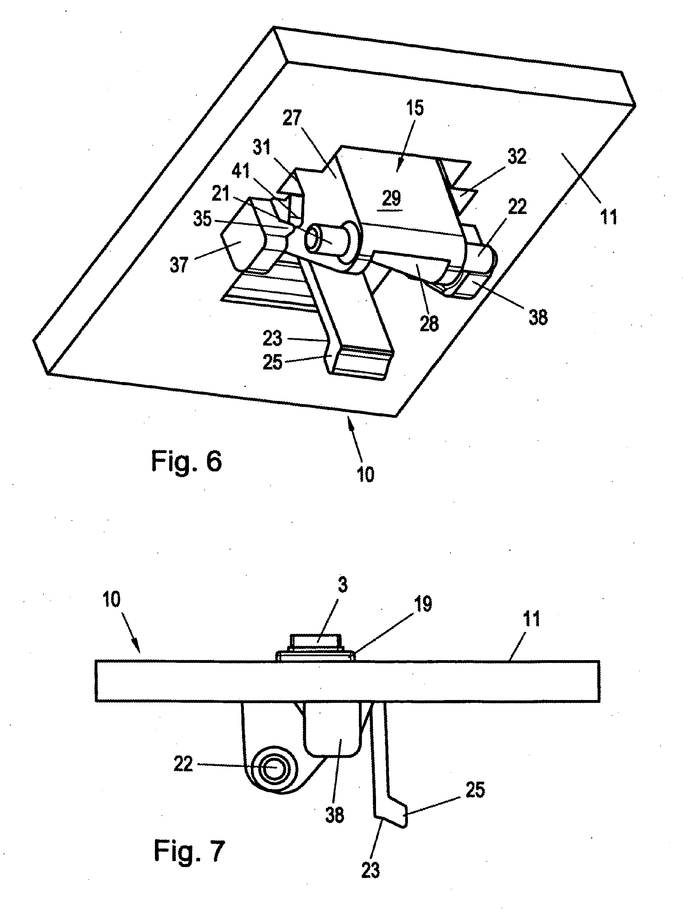

In ähnlicher Weise hat der Sockel 15 senkrecht von seinem plattenförmigen Hauptkörper 24 nach unten abstehende Schenkel 27, 28, vgl. insbesondere Fig. 5 und 6, die je einen der Zapfenvorsprünge 21 bzw. 22 tragen, und die sich am gemäß der Darstellung etwa in Fig. 2 vorderen (unteren) Ende durch eine ebenfalls senkrecht nach unten abstehende Wand 29 zu einem stabilen dreiseitigen Rahmengebilde ergänzen.

In der Ausgangsposition gemäß den Fig. 4 bis 9 sind in Draufsicht rechteckige, direkt an das Fenster 13 anschließende, d.h. zum Inneren des Fensters 13 hin offene Durchbrechungen 31, 32 in vertikaler Ausrichtung zu den Zapfenvorsprüngen 21, 22 im plattenförmigen Tragkörper 11 vorgesehen, um so das Formen der Zapfenvorsprünge 21, 22 von oben her in einer bloß zweiteiligen Spritzgussform zu ermöglichen. Vergleichbare fensterartige Durchbrechungen 33, 34 sind im plattenförmigen Tragkörper 11 in der Montage- oder Ausgangsposition in vertikaler Ausrichtung zu Rasten 35, 36 für die Zapfenvorsprünge 31, 32 vorgesehen, s. beispielsweise Fig. 4 und 5.

Die Rasten 35, 36 sind wiederum an vom plattenförmigen Tragkörper 11 rechtwinkelig nach unten abstehenden Lagerteilen oder Schenkeln 37 bzw. 38 angebracht, wie insbesondere in den Fig. 11 und 12 ersichtlich ist. Da diese Schenkel 37, 38 von keinen anderen Elementen zu hintergreifen sind, und so direkt an der Unterseite des plattenförmigen Tragkörpers 11 angeformt werden können, sind sie beim Formen durch Spritzgießen unkritisch, wohl aber werden wie insbesondere aus Fig. 12 ersichtlich die Rasten 35, 36 von den Zapfenvorsprüngen 21, 22 in der Betriebsposition (s. Fig. 12, aber auch Fig. 17 und 18) hintergriffen, so dass sowohl ihre Oberseite als auch ihre Unterseite unterhalb des Platten-Hauptteils des Tragkörpers 11 zu formen sind, wobei dadurch die Durchbrechungen 33, 34 entstehen. Die Rasten 35, 36 sind in der Art von Rastnischen (s. Fig. 17 und 18) mit entsprechend den Zapfenvorsprüngen 21, 22 im Querschnitt angepassten, insbesondere Kreisbogen-förmigen Rastnischen ausgebildet. Die Rasten 35, 36 sind weiters an ihrer Unterseite mit Schrägflächen 39, 40 versehen, s. z.B. Fig. 12, an denen die Zapfenvorsprünge 21, 22 wie aus Fig. 11 ersichtlich beim Verschwenken des Sockels 15 in die Betriebslage insbesondere mit abgeschrägten Enden entlang gleiten; dabei biegen sie die Lagerteile bzw. Schenkel 37, 38 aus, bis sie über den Rasten 35, 36 vorliegen und unter elastischem Zurückschwenken der Lagerteile bzw. der Schenkel 37, 38 in die Rastnischen 35, 36 einschnappen. In dieser Raststellung, entsprechend der endgültigen Betriebsposition, wird eine Bewegung der Zapfenvorsprünge 21, 22 nach oben weiters durch entsprechend geformte Anschläge 41, 42 begrenzt, die an der Unterseite des Hauptteils des plattenförmigen Tragkörpers 11 angeformt sind, s. Fig. 11 und 12. Zwischen jeweils einem Anschlag 41 bzw. 42 und einem Schenkel 37 bzw. 38 befindet sich die jeweilige Durchbrechung 33 bzw. 34, s. insbesondere auch Fig. 5.

Nach dem Spritzgießen der Trageinheit 10 werden in der Ausgangsposition oder Montageposition gemäß den Fig. 2 bis 9 wie erwähnt noch vor dem 2D-Bestücken, um die LED 3 anzubringen, die Leiterbahnen 18 aufgebracht, wonach die Trageinheit 10 in einem Heiztunnel (nicht gezeigt) erhitzt wird, um ein aufgebrachtes Lot bzw. Leitermaterial zu erhitzen, wonach im 2D-Bestücker (nicht gezeigt) die LED 3 zwischen den Positionierleisten 19 aufgebracht wird. Nach Verfestigen des Lots bzw. Leitermaterials sitzt die LED 3 fest auf dem Sockel 15.

Beim Bestücken in 2D-Technologie kann die Trageinheit 10 beispielsweise auf einem intermittierend angetriebenen Förderer aufliegen, der im Bereich des Sockels 15 (mit dessen unteren Zapfenvorsprüngen 21, 22 an den Schenkeln 37, 38 sowie auch dem Schnapphaken 23) Ausnehmungen hat, so dass der plattenförmige Tragkörper 11 im Übrigen mit seiner etwa aus Fig. 6 ersichtlichen Unterseite plan auf dem Förderer aufliegen kann.

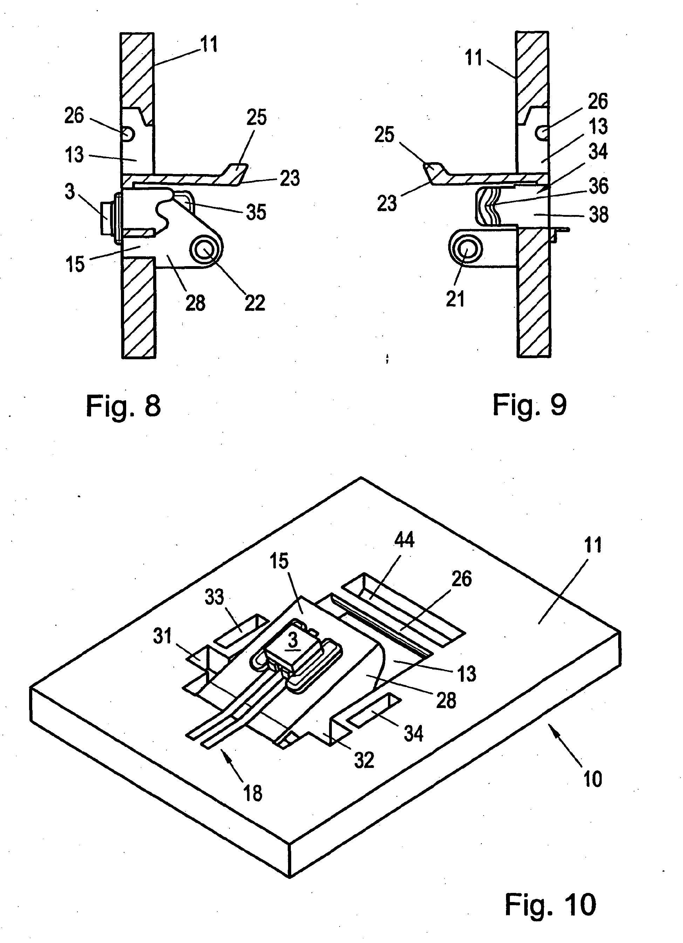

Nach dem Bestücken wird der Sockel 15 in seine Betriebsposition gemäß Fig. 2 hochgeschwenkt, wobei aus Fig. 10 und 11 eine Zwischenstellung bei diesem Hochschwenken ersichtlich ist. Ein Vergleich insbesondere der Fig. 11 und 12 zeigt, wie die Zapfenvorsprünge 21, 22 schließlich in der Betriebsposition durch Verrasten an den Elementen 41/35 bzw. 42/36 fixiert werden.

In ähnlicher Weise wird der Schnapphaken 23 mit seinem Hakenende 25 am Steg 26 verrastet, wobei er mit seiner Unterseite an einem Absatz 43 (s. Fig. 17) des Tragkörpers 11 aufliegt. Dadurch wird der Sockel 15 sicher und stabil in seiner Betriebsposition gemäß den Fig. 2 und 12 bis 17 festgehalten, und zwar in der Art der erwähnten "Dreipunkt-Lagerung", die durch die beiden seitlichen Zapfenvorsprünge 21, 22 sowie den Schnapphaken 23 gegeben ist.

Auch für den Absatz 43 (s. Fig. 17) gilt wiederum - in Relation zur Leiste 26 - der Vorteil der einfachen Formung durch Spritzgießen, da in einer vertikalen Projektion gesehen die Leiste 26 nicht über dem Absatz 43 vorliegt, vielmehr in vertikaler Ausrichtung zum Absatz 43 ein Fensterteil oder eine Durchbrechung 44 im Tragkörper 11 vorliegt, s. Fig. 17 sowie Fig. 10 und 13.

Die Positionen und Abmessungen der einzelnen Rastelemente 20 sind dabei selbstverständlich je nach Winkellage des Sockels 15 relativ zum übrigen Tragkörper 11 in der Betriebslage festzulegen. Je nach Anwendung können sich dabei verschiedene Winkellagen, d.h. mit verschiedenen Winkeln α (s. Fig. 1A und 1B) als notwendig ergeben, und die jeweilige Winkellage kann durch die Länge des Schnapphakens 23, durch die Position der Stege 26 und des Absatzes 43, durch die Position der Zapfenvorsprünge 21, 22 (d.h. die Länge der Schenkel 27, 28) sowie die Länge der Schenkel 37, 38 und die Positionen der Rasten 35, 36 bestimmt werden.

In Fig. 19 ist schließlich noch schematisch eine Trageinheit 10 mit einer Mehrzahl von Sockeln 15, mit einem entsprechenden Leiterbahnenmuster 18, gezeigt, um so zu veranschaulichen, dass an einem gemeinsamen plattenförmigen Tragkörper 11 mit einer Mehrzahl von Fenstern 13 und Sockeln 15 eine entsprechende Mehrzahl von LEDs 3 oder allgemein Lichtquellen 2 (s. Fig. 1) vorgesehen werden kann, wobei in entsprechender Weise wie vorstehend anhand der Fig. 2 bis 18 erläutert die erfindungsgemäße Technik im Hinblick auf die gewünschte 2D-Bestückung angewandt werden kann.

Selbstverständlich können auch mehr oder weniger LEDs als die gezeigten acht LEDs 3 gemäß Fig. 19 vorgesehen werden, und ebenso ist es möglich, an ein und dem selben Sockel 15 mehr als eine LED 3, z.B. zwei, aber auch zehn oder zwanzig, anzubringen.

Als Material für den Tragkörper 11 samt Sockel 15 kann jedes für den jeweiligen Anwendungszweck geeignete Kunststoffmaterial verwendet werden. Im Hinblick auf das Heißprägen der MID-Leiterbahnen 18 wird ein Thermoplast bevorzugt.

## Patentansprüche

1. Lichtquellen-Trageinheit mit einem Tragkörper, der wenigstens einen Montagebereich für die Montage zumindest einer Lichtquelle, vorzugsweise einer LED, aufweist, und der eine Bezugsebene definiert, gegenüber welcher die Lichtabstrahlrichtung der Lichtquelle in der vorgegebenen Betriebsposition geneigt verläuft, wobei der Montagebereich (14) durch einen mit dem übrigen Tragkörper (11) beweglich verbundenen Sockel (15) gebildet ist, der relativ zum Tragkörper (11) aus einer anfänglichen Lichtquellen-Montageposition, entsprechend der Bezugsebene, in die Betriebsposition bewegbar ist, **dadurch gekennzeichnet, dass** der Sockel (15) und der Tragkörper (11) in der Betriebsposition zusammenarbeitende Rastelemente (20) aufweisen.

2. Trageinheit nach Anspruch 1, **dadurch gekennzeichnet, dass** der Tragkörper (11)zumindest im Wesentlichen plattenförmig ist, wobei die Plattenebene die Bezugsebene (12) definiert.

3. Trageinheit nach Anspruch 1 oder 2, **dadurch gekennzeichnet, dass** der Sockel (15) in einer fensterartigen Öffnung (13) des Tragkörpers (11) angeordnet ist.

4. Trageinheit nach einem der Ansprüche 1 bis 3, **dadurch gekennzeichnet, dass** der Sockel (15) mit dem Tragkörper (11) schwenkbar verbunden ist.

5. Trageinheit nach Anspruch 4, **dadurch gekennzeichnet, dass** der Sockel (15) mit dem Tragkörper (11) einstückig ist und mit ihm über ein Filmscharnier (17) schwenkbar verbunden ist.

6. Trageinheit nach Anspruch 5, **dadurch gekennzeichnet, dass** am Sockel (15) sowie am Tragkörper (11) über den Bereich des Filmscharniers (17) führende flexible Leiterbahnen (18) für den elektrischen Anschluss der Lichtquelle (2) angeordnet sind.

7. Trageinheit nach einem der Ansprüche 1 bis 6, **dadurch gekennzeichnet, dass** der Sockel (15) zumindest einen abstehenden Zapfenvorsprung (21, 22) aufweist, der in eine Raste (35, 36) am Tragkörper (11) einschnappt.

8. Trageinheit nach Anspruch 7, **dadurch gekennzeichnet, dass** die Raste (35, 36) am Tragkörper (11) nischenartig in einem am Tragkörper (11) vorgesehenen Lagerteil (37, 38) gebildet ist, und dass am Tragkörper (11) weiters ein Anschlag (41, 42) für den Zapfenvorsprung (21, 22) vorgesehen ist, an welchem letzterer in der Betriebsposition anliegt.

9. Trageinheit nach Anspruch 7 oder 8, **dadurch gekennzeichnet, dass** der Zapfenvorsprung (21, 22) an einem von einem plattenförmigen Hauptkörper des Sockels (15) abstehenden Schenkel (27, 28) angebracht ist.

10. Trageinheit nach einem der Ansprüche 6 bis 9, **dadurch gekennzeichnet, dass** der Sockel (15) einen mit dem Tragkörper (11) verrastbaren Schnapphaken (23) aufweist.

11. Trageinheit nach Anspruch 10, **dadurch gekennzeichnet, dass** der Schnapphaken (23) laschenartig vom übrigen Sockel (15) absteht.

12. Trageinheit nach Anspruch 10 oder 11, **dadurch gekennzeichnet, dass** am Tragkörper (11) ein Steg (26) vorgesehen ist, den der Schnapphaken (23) in der Betriebsposition mit einem Hakenende (25) hintergreift.

13. Trageinheit nach einem der Ansprüche 1 bis 12, **dadurch gekennzeichnet, dass** der Sockel (15), z.B. leistenförmige, Positioniervorsprünge (19) für eine LED (3) aufweist.

14. Trageinheit nach einem der Ansprüche 6 bis 13, **dadurch gekennzeichnet, dass** der Tragkörper (11) zu den Rastelementen (20) in der Montageposition des Sockels ausgerichtete Durchbrechungen (31, 32, 33, 34) aufweist.

## Claims

1. A supporting assembly for light sources, including a supporting body with at least one mounting region for mounting of at least one light source, preferably an LED, the supporting body defining at least one reference plane, the light-emission direction of the light source extending in an inclined relationship to the reference plane in the predefined operational position, wherein the mounting region (14) is comprised of a base (15) movably connected to the rest of the supporting body (11), the base (15) being movable from an initial light-source mounting position in correspondence with the reference plane into the operational position relative to the supporting body (11), **characterized in that** in the operational position, the base (15) and the supporting body (11) have cooperating snap-in elements (20).

2. The supporting assembly according to claim 1, **characterized in that** the supporting body (11) is at least substantially plate-shaped, wherein the plane of the plate defines the reference plane (12).

3. The supporting assembly according to claim 1 or 2, **characterized in that** the base (15) is arranged in a window-type opening (13) of the supporting body (11).

4. The supporting assembly according to any one of claims 1 to 3, **characterized in that** the base (15) is pivotally connected to the supporting body (11).

5. The supporting assembly according to claim 4, **characterized in that** the base (15) is integral with the supporting body (11) and pivotally connected to the same via a film hinge (17).

6. The supporting assembly according to claim 5, **characterized in that** flexible conductive paths (18) for electric connection of the light source (2) are provided on the base (15) and on the supporting body (11) across the region of the film hinge (17).

7. The supporting assembly according to any one of claims 1 to 6, **characterized in that** the base (15) has at least one protruding pin projection (21, 22) which snaps into an indentation (35, 36) on the supporting body (11).

8. The supporting assembly according to claim 7, **characterized in that** the indentation (35, 36) on the supporting body (11) is formed in a bearing element (37, 38) to be recess-shaped, with the bearing element (37, 38) being provided at the supporting body (11), and that a stop (41, 42) for the pin projection (21, 22) is furthermore provided on the supporting body (11), with the latter being placed against the stop (41, 42) in the operational position.

9. The supporting assembly according to claim 7 or 8, **characterized in that** the pin projection (21, 22) is attached to a leg (27, 28) which protrudes from a plate-shaped main body of the base (15).

10. The supporting assembly according to any one of claims 6 to 9, **characterized in that** the base (15) has a snap-in hook (23) which is engageable with the supporting body (11).

11. The supporting assembly according to claim 10, **characterized in that** the snap-in hook (23) protrudes from the rest of the base (15) in a lug-like manner.

12. The supporting assembly according to claim 10 or 11, **characterized in that** a web (26) is provided on the supporting body (11) which the snap-in hook (23) engages with a hook end (25) in the operational position.

13. The supporting assembly according to any one of claims 1 to 12, **characterized in that** the base (15) has, e.g. ledge-shaped, positioning projections (19) for an LED (3).

14. The supporting assembly according to any one of claims 6 to 13, **characterized in that** the supporting body (11) has through-holes (31, 32, 33, 34) oriented towards the snap-in elements (20) in the assembling position of the base.

## Revendications

1. Unité porteuse de source lumineuse comprenant un corps porteur, qui comporte au moins une zone de montage pour le montage d'au moins une source lumineuse, de préférence une DEL, et qui définit un plan de référence, par rapport auquel la direction du faisceau de la source lumineuse est inclinée dans la position de service prédéfinie, la zone de montage (14) étant formée par un socle (15) relié de façon mobile au corps porteur (11) restant, lequel socle peut être déplacé par rapport au corps porteur (11) à partir d'une position de montage initiale de source lumineuse, en fonction du plan de référence, dans la position de service, **caractérisée en ce que** le socle (15) et le corps porteur (11) comportent des éléments d'encliquetage (20) coopérant dans la position de service.

2. Unité porteuse selon la revendication 1, **caractérisée en ce que** le corps porteur (11) est au moins essentiellement en forme de plaque, le plan de plaque définissant le plan de référence (12).

3. Unité porteuse selon la revendication 1 ou 2, **caractérisée en ce que** le socle (15) est disposé dans une ouverture (13) de type fenêtre du corps porteur (11).

4. Unité porteuse selon l'une quelconque des revendications 1 à 3, **caractérisée en ce que** le socle (15) est relié de façon basculante au corps porteur (11).

5. Unité porteuse selon la revendication 4, **caractérisée en ce que** le socle (15) forme une seule pièce avec le corps porteur (11) et est relié de façon basculante avec lui au moyen d'une charnière en film (17).

6. Unité porteuse selon la revendication 5, **caractérisée en ce que** des pistes conductrices (18) flexibles, directrices par la zone de la charnière en film (17), pour le raccordement électrique de la source lumineuse (2) sont disposées sur le socle (15) et sur le corps porteur (11).

7. Unité porteuse selon l'une quelconque des revendications 1 à 6, **caractérisée en ce que** le socle (15) comporte au moins une saillie à tenon (21, 22) débordante qui s'enclenche dans une encoche (35, 36) sur le corps porteur (11).

8. Unité porteuse selon la revendication 7, **caractérisée en ce que** l'encoche (35, 36) sur le corps porteur (11) est formée à la façon d'une niche dans une partie d'appui (37, 38) prévue sur le corps porteur (11), et **en ce qu'**il est prévu sur le corps porteur (11) également une butée (41, 42) pour la saillie à tenon (21, 22), sur laquelle cette saillie s'applique dans la position de service.

9. Unité porteuse selon la revendication 7 ou 8, **caractérisée en ce que** la saillie à tenon (21, 22) est placée sur une branche (27, 28) débordant d'un corps principal en forme de plaque du socle (15).

10. Unité porteuse selon l'une quelconque des revendications 6 à 9, **caractérisée en ce que** le socle (15) présente un crochet d'encliquetage (23) emboîtable avec le corps porteur (11).

11. Unité porteuse selon la revendication 10, **caractérisée en ce que** le crochet d'encliquetage (23) dépasse du socle (15) restant à la façon d'une patte.

12. Unité porteuse selon la revendication 10 ou 11, **caractérisée en ce qu'**il est prévu, sur le corps porteur (11), une nervure (26) que le crochet d'encliquetage (23) saisit par l'arrière dans la position de service avec une extrémité de crochet (25).

13. Unité porteuse selon l'une quelconque des revendications 1 à 12, **caractérisé en ce que** le socle (15) présente des saillies de positionnement (19), par exemple en forme de baguette, pour une DEL (3).

14. Unité porteuse selon l'une quelconque des revendications 6 à 13, **caractérisée en ce que** le corps porteur (11) présente des percements (31, 32, 33, 34) alignés sur les éléments d'encliquetage (20) dans la position de montage du socle.
